# EUROPEAN PATENT APPLICATION

(11) **EP 4 576 521 A1**
(43) Date of publication of application: **25.06.2025**
(21) Application number: 23854218.7
(22) Date of filing: 28.07.2023
(51) Int. Cl.: H02K 11/30, H02K 11/00, H02K 5/22, H02K 11/215, H02K 5/10, B60K 1/00, B60R 16/02

(54) **ELECTRIC ASSEMBLY AND VEHICLE HAVING SAME**

(30) Priority: 18.08.2022 CN 202222187926 U
(71) Applicant: BYD Company Limited, Shenzhen, Guangdong 518118 (CN)
(72) Inventor: QI, Axi, Shenzhen, Guangdong 518118 (CN); YU, Fengchuan, Shenzhen, Guangdong 518118 (CN); ZHANG, Xingchun, Shenzhen, Guangdong 518118 (CN)
(74) Representative: Mathys & Squire
(86) International application number: PCT/CN2023/109966
(87) International publication number: WO 2024/037314

(57) **Abstract**

A vehicle, having an electric assembly, wherein the electric assembly comprises a box body, an electric control module, and a motor. The electric control module is arranged in the box body. The motor is arranged in the box body, and comprises a casing, an N-line connecting assembly, an end cover, and a three-phase winding. One end of the N-line connecting assembly is configured to be connected to a battery pack. The three-phase winding is arranged in the casing, a first end of the three-phase winding is connected to the electric control module, a second end of the three-phase winding is connected to a junction and then to the other end of the N-line connecting assembly, the end cover is arranged at one end of the casing and used for blocking the casing, and an opening allowing part of the N-line connecting assembly to pass through is formed in the end cover.

## Description

### CROSS-REFERENCE TO RELATED APPLICATIONS

The present disclosure claims priority to Chinese Patent Application No. 202222187926.9, filed on August 18, 2022 and entitled "ELECTRIC ASSEMBLY AND VEHICLE WITH SAME". The entire content of the above-referenced application is incorporated herein by reference.

### FIELD

The present disclosure relates to the field of vehicle technologies, and in particular, to an electric assembly and a vehicle having the same.

### BACKGROUND

An electric assembly in the related art usually integrates a motor, an electric cabinet, and a gearbox. With the development of technologies, a high-density integrated electric assembly that integrates the motor, the electric cabinet, the gearbox, a high-voltage power distributor unit (PDU), an on-board charger (OBC), a DC/DC converter, and an electronic device having other electrical functions is becoming an increasingly popular trend in the development of new energy vehicles. Under the trend, the weight and costs of the electric assembly become the focus of attention, and arrangement of the vehicle and N wire connection need to be optimized.

### SUMMARY

The present disclosure is intended to resolve at least one of technical problems existing in the related art. Therefore, an object of the present disclosure is to provide an electric assembly. The electric assembly has advantages such as a short wiring distance, a simple wiring structure, and a small volume.

According to the present disclosure, a vehicle having the above electric assembly is further provided.

In order to achieve the above object, according to an embodiment of a first aspect of the present disclosure, an electric assembly is provided. The electric assembly comprises a box, an electric control module, and a motor. The electric control module is arranged in the box. The motor is arranged in the box. The motor comprises a casing, an N wire connection assembly, an end cover, and three-phase windings arranged in the casing. One end of the N wire connection assembly is configured to connect to a battery pack. A first end of the three-phase windings is connected with the electric control module, and a second end of the three-phase windings is connected with a junction and then connected with another end of the N wire connection assembly. The end cover is arranged at one end of the casing and configured to block the casing. An opening allowing part of the N wire connection assembly to pass through is formed in the end cover.

The electric assembly according to this embodiment of the present disclosure has advantages such as a short wiring distance, a simple wiring structure, and a small volume.

According to some embodiments of the present disclosure, the N wire connection assembly comprises an N wire, an N wire adapter, and an N wire terminal block. A first end of the N wire is connected with the second end of the three-phase windings. A first end of the N wire adapter is connected with a second end of the N wire. A second end of the N wire adapter passes through the opening. A first end of the N wire terminal block is connected with a second end of the N wire. A second end of the N wire terminal block is connected with an N wire copper bar of the electric control module.

According to some embodiments of the present disclosure, a Hall element is arranged to extend through the N wire copper bar. The Hall element is connected with the electric control module through a signal wire.

According to some embodiments of the present disclosure, the electric assembly further comprises a contactor. A first end of the contactor being configured to connect to the battery pack. A second end of the contactor being configured to connect to the N wire connection assembly.

According to some embodiments of the present disclosure, the N wire adapter passes through the opening and is then connected with the N wire lug. The N wire lug is configured to connect to the battery pack through a lead wire.

According to some embodiments of the present disclosure, the motor further comprises an N wire fixing base. The N wire fixing base is mounted to the end cover. The N wire adapter comprises a first connector. The first connector is inserted into the N wire fixing base.

According to some embodiments of the present disclosure, the N wire lug comprises a second connector. The first connector is connected with the second connector.

According to some embodiments of the present disclosure, the motor further comprises an N wire mounting and dismounting cover. A side of the N wire fixing base facing away from the end cover is provided with a mounting and dismounting port. The N wire mounting and dismounting cover is mounted to the N wire fixing base and covers the mounting and dismounting port. The mounting and dismounting port is configured to mount and dismount at least one of the first connector and the second connector.

According to some embodiments of the present disclosure, the motor further comprises a first sealing ring and a second sealing ring. The first sealing ring surrounds the opening and is arranged between the N wire fixing base and the end cover. The second sealing ring surrounds the mounting and dismounting port and is arranged between the N wire fixing base and the N wire mounting and dismounting cover.

According to some embodiments of the present disclosure, the electric assembly further comprises a three-phase wire connection assembly. The three-phase wire connection assembly comprises a three-phase wire and a three-phase wire terminal block. The three-phase wire is connected with the three-phase windings. The three-phase wire terminal block is connected with the electric control module. The three-phase wire terminal block and the N wire terminal block are integrally formed.

According to some embodiments of the present disclosure, a peripheral surface of one end of the casing close to the end cover is provided with a motor terminal block slot. The three-phase wire terminal block passes through the motor terminal block slot and is fixedly mounted to the casing. One end of the three-phase wire terminal block connected with the motor passes through the motor terminal block slot and enters a cavity formed by the end cover and the casing. One end of the three-phase wire terminal block connected with the electric control module protrudes from the motor terminal block slot.

According to some embodiments of the present disclosure, the electric assembly further comprises a third sealing ring. The third sealing ring surrounds the motor terminal block slot and is located between the three-phase wire terminal block and the end cover.

According to some embodiments of the present disclosure, the electric assembly further comprises a water channel cover plate. The water channel cover plate is provided with a first water channel. The box is provided with a second water channel and a third water channel. The water channel cover plate is connected with the box and covers the second water channel and the third water channel.

According to some embodiments of the present disclosure, the electric assembly further comprises a power module. The power module is arranged in the box. The first water channel is in communication with the second water channel and the third water channel. The electric assembly further comprises a water inlet pipe and a water outlet pipe. The water inlet pipe is adapted to be in communication with the second water channel. The water outlet pipe is adapted to be in communication with the third water channel. A cooling liquid in the second water channel is adapted to flow into the first water channel to dissipate heat for the electric control module. A cooling liquid in the first water channel is adapted to flow into the third water channel to dissipate heat for the power module.

According to some embodiments of the present disclosure, the third water channel comprises a transition section and an annular section. The transition section is brought into communication with the first water channel. The annular section surrounds the power module and is configured to dissipate heat for the power module.

According to some embodiments of the present disclosure, one end of the annular section is connected with one end of the transition section, and another end of the annular section is provided with a water outlet hole. A depth of the annular section is greater than a depth of the second water channel and a depth of the transition section.

According to an embodiment of a second aspect of the present disclosure, a vehicle is provided. The vehicle comprises the electric assembly according to the embodiment of the first aspect of the present disclosure.

The vehicle according to the embodiment of the second aspect of the present disclosure has advantages such as a short wiring distance, a simple wiring structure, and a small volume by utilizing the electric assembly according to the embodiment of the first aspect of the present disclosure.

Additional aspects and advantages of the present disclosure are to be partially given in the following description, some of which become apparent from the following description or may be learned by practice of the present disclosure.

### BRIEF DESCRIPTION OF THE DRAWINGS

The above and/or additional aspects and advantages of the present disclosure become apparent and comprehensible from the following descriptions of embodiments with reference to accompanying drawings below.
FIG. 1 is a schematic structural diagram of an electric assembly according to an embodiment of the present disclosure;
FIG. 2 is a principle diagram of an electric assembly according to an embodiment of the present disclosure;
FIG. 3 is an exploded view of an electric assembly according to an embodiment of the present disclosure;
FIG. 4 is an exploded view of a motor according to an embodiment of the present disclosure;
FIG. 5 is a schematic structural diagram of a box and an electric control module of an electric assembly according to an embodiment of the present disclosure;
FIG. 6 is a schematic structural diagram of a box of an electric assembly according to an embodiment of the present disclosure;
FIG. 7 is a schematic structural diagram of a water channel cover plate according to an embodiment of the present disclosure; and
FIG. 8 is a schematic block diagram of a vehicle according to an embodiment of the present disclosure.

In the drawings:
1. Electric assembly; 100. Box; 110. Second water channel; 120. Third water channel; 121. Transition section; 122. Annular section; 123. Water outlet hole; 130. Water inlet pipe; 140. Water outlet pipe; 150. MOS tube cavity; 160. AC inductor cavity; 170. DC inductor cavity;
200. Electric control module; 210. N wire copper bar; 220. Hall element; 300. Power module; 310. Bottom plate; 320. Transformer; 330. Transformer inductor; 340. MOS tube; 350. AC inductor; 360. DC inductor; 400. Motor; 410. Casing; 411. Motor terminal block slot; 420. N wire connection assembly; 4201. One end of the N wire connection assembly; 4202. Another end of the N wire connection assembly; 421. N wire; 4211. First end of the N wire; Second end of the N wire; 422. N wire adapter; 4221. First end of the N wire adapter; 4222. Second end of the N wire adapter; 423. N wire terminal block; 4231. First end of the N wire terminal block; 4232. Second end of the N wire terminal block; 424. N wire lug; 425. Second connector; 430. End cover; 431. Opening; 440. Three-phase windings; 4401. First ends of the three-phase windings; 4402. Second ends of the three-phase windings; 450. N wire fixing base; 451. First connector; 452. Mounting and dismounting port; 460. N wire mounting and dismounting cover; 470. First sealing ring; 480. Second sealing ring; 500. Contactor; 5001. First end of the contactor; 5002. Second end of the contactor; 600. Three-phase wire connection assembly; 610. Three-phase wire; 620. Three-phase wire terminal block; 700. Third sealing ring; 800. Water channel cover plate; 810. First water channel; 900. Battery pack; and Vehicle 1000.

### DETAILED DESCRIPTION

The embodiments of the present disclosure are described below in detail. Examples of the embodiments are shown in the accompanying drawings, and same or similar reference numerals throughout represent same or similar elements or elements having same or similar functions. The embodiments described below with reference to the accompanying drawings are exemplary, and are merely intended to explain the present disclosure and cannot be construed as a limitation to the present disclosure.

In the description of the present disclosure, it should be understood that orientation or position relationships indicated by the terms such as "center", "longitudinal", "transverse", "length", "width", "thickness", "on", "below", "front", "back", "left", "right", "vertical", "horizontal", "top", "bottom", "inside", "outside", "axial", "radial", and "circumferential" are based on orientation or position relationships shown in the accompanying drawings, and are used only for ease and brevity of illustration and description, rather than indicating or implying that the mentioned apparatus or component needs to have a particular orientation or be constructed and operated in a particular orientation. Therefore, such terms should not be construed as a limitation on the present disclosure.

In the description of the present disclosure, "first feature" and "second feature" may comprise one or more of the features.

In the description of the present disclosure, "a number of" means two or more than two, and "several" means one or more.

An electric assembly 1 according to an embodiment of the present disclosure is described below with reference to the accompanying drawings.

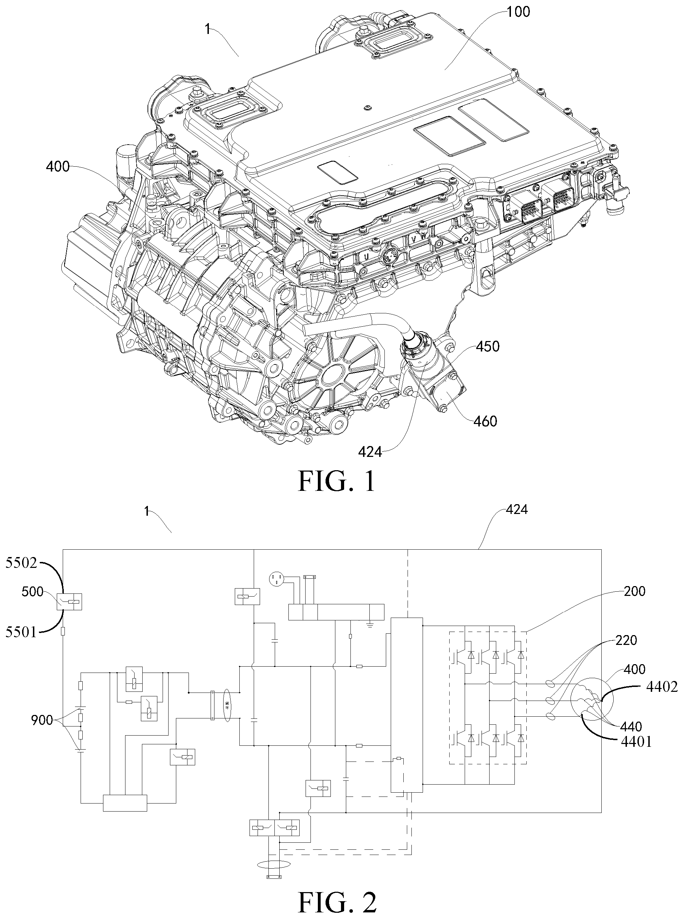

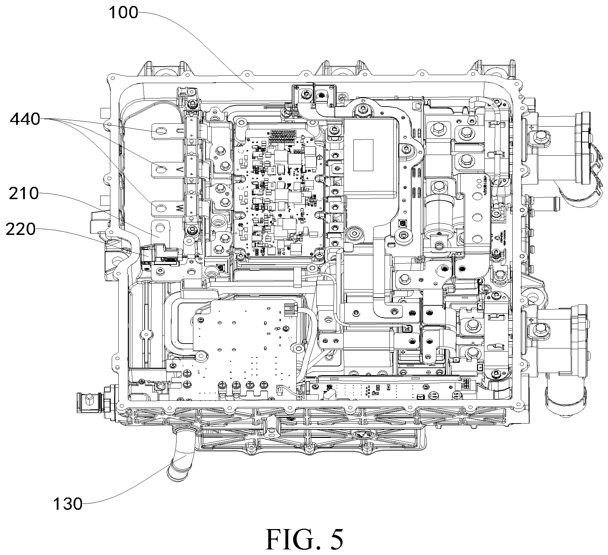

As shown in FIG. 1 to FIG. 7, the electric assembly 1 according to this embodiment of the present disclosure comprises a box 100, an electric control module 200, and a motor 400.

The electric control module 200 is arranged in the box 100, and the motor 400 is arranged in the box 100. The motor 400 comprises a casing 410, an N wire connection assembly 420, an end cover 430, and three-phase windings 440 arranged in the casing 410. One end 4201 of the N wire connection assembly 420 is configured to connect to a battery pack 900. A first end 4401 of the three-phase windings 440 is connected with the electric control module 200, and a second end 4402 of the three-phase windings 440 is connected with a junction and then connected with another end 4202 of the N wire connection assembly 420. The end cover 430 is arranged at one end of the casing 410 and configured to block the casing 410, and an opening 431 allowing part of the N wire connection assembly 420 to pass through is formed in the end cover 430.

According to the electric assembly 1 of this embodiment of the present disclosure, through arrangement of the electric control module 200 on the box 100 and the motor 400 on the box 100, the box 100 may fix the electric control module 200 and the motor 400, and may simultaneously protect the electric control module 200 and the motor 400, which is convenient for fixing a layout of the electric control module 200 and the motor 400 and avoids interference between the electric control module 200 and the motor 400.

In addition, the motor 400 comprises a casing 410, an N wire connection assembly 420, an end cover 430, and three-phase windings 440 arranged in the casing 410. One end 4201 of the N wire connection assembly 420 is configured to connect to a battery pack 900. A first end 4401 of the three-phase windings 440 is connected with the electric control module 200, and a second end 4402 of the three-phase windings 440 is connected with a junction and then connected with the other end 4202 of the N wire connection assembly 420. In this way, the battery pack 900 may be connected with the three-phase windings 440 through the N wire connection assembly 420.

In this way, the battery pack 900, the N wire connection assembly 420, the three-phase windings 440, and the electric control module 200 may be connected as a heating circuit, so that the battery pack 900 can be heated, and the three-phase windings 440 of the motor 400 and the electric control module 200 are reused, thereby reducing a quantity of parts, increasing a space utilization rate, and reducing costs.

In addition, the end cover 430 is arranged at one end of the casing 410 and configured to block the casing 410, and an opening 431 for the N wire connection assembly 420 to pass through is formed in the end cover 430. In other words, after the N wire connection assembly 420 is connected with the second end 4402 of the three-phase windings 440, the N wire connection assembly 420 may directly extend out of the casing 410 from the opening 431 of the end cover 430, so that the N wire connection assembly 420 can be connected with the battery pack 900.

Through this arrangement, compared with the electric assembly in which the N wire connection assembly is routed through the box and is connected with the battery pack in the related art, the N wire connection assembly 420 extends through the opening 431 of the end cover 430 and is connected with the battery pack 900, so that the wiring distance can be shortened. Moreover, the wiring layout between a junction terminal of the three-phase windings 440 and the battery pack 900 is also simpler, so that the layout of the electric assembly 1 is neater and the mounting and dismounting are more convenient, and can reduce the weight and cost of the electric assembly 1.

Moreover, since a voltage between the junction terminal of the three-phase windings 440 and the battery pack 900 is usually high, a cross-sectional area of the N wire connection assembly 420 between the junction terminal of the three-phase windings 440 and the battery pack 900 needs to be set to be large. In the present disclosure, the wiring of the N wire connection assembly 420 between the junction terminal of the three-phase windings 440 and the battery pack 900 is not arranged inside the box 100, so that the volume of the box 100 can be reduced, electromagnetic interference is not generated to the electric control module 200, and the control of the electric control module 200 is simpler.

In this way, the electric assembly 1 according to this embodiment of the present disclosure has advantages such as a short wiring distance, a simple wiring structure, and a small volume.

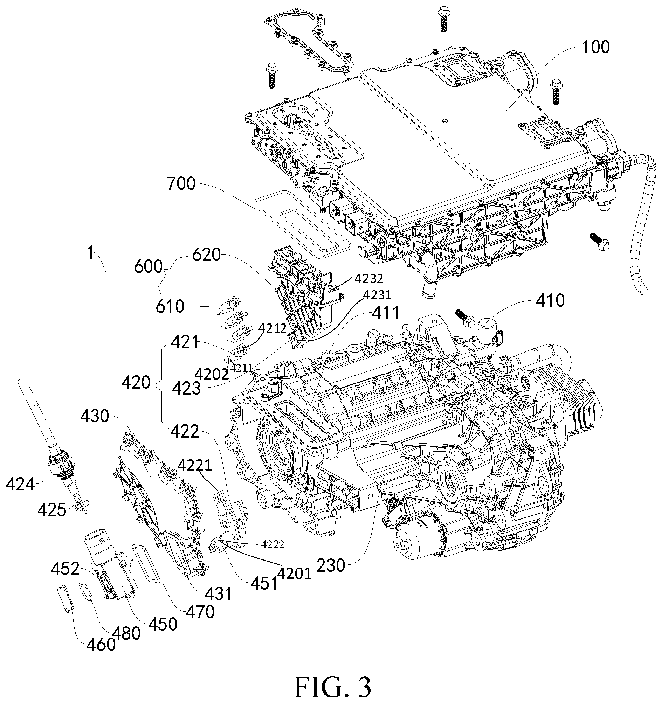

In some specific embodiments of the present disclosure, as shown in FIG. 3, the N wire connection assembly 420 comprises an N wire 421, an N wire adapter 422, and an N wire terminal block 423.

A first end 4211 of the N wire 421 is connected with the second end 4402 of the three-phase windings 440. The first end 4211 of the N wire 421 is the other end 4202 of the N wire connection assembly 420. A first end 4221 of the N wire adapter 422 is connected with a second end 4212 of the N wire 421, and a second end 4222 of the N wire adapter 422 passes through the opening 431. The second end 4222 of the N wire adapter 422 is the end 4201 of the N wire connection assembly 420. A first end 4231 of the N wire terminal block 423 is connected with the second end 4212 of the N wire 421, and a second end 4232 of the N wire terminal block 423 is connected with an N wire copper bar 210 of the electric control module 200.

Further, a Hall element 220 is arranged to extend through the N wire copper bar 210, and the Hall element 220 is connected with the electric control module 200 through a signal wire.

In this way, the N wire terminal block 423 may connect the N wire 421 to the N wire copper bar 210 of the electric control module 200, and the N wire adapter 422 may connect the junction terminal of the three-phase windings 440 to outside of the casing 410 of the motor 400, which is convenient for connecting the junction terminal of the three-phase windings 440 to the battery pack 900. In this way, the wiring of the N wire connection assembly 420 is simpler, and the wiring distance is shorter, which is convenient for the layout.

The arrangement of the N wire 421 and the N wire terminal block 423 can realize the connection between the three-phase windings 440 and a charging base of a vehicle, so that when the charging base is connected with a charging box with a low charging voltage (for example, a charging voltage is 450 V), a charging current may be guided to the three-phase windings 440 and a bridge arm of the electric control module 200 through the N wire 421 and the N wire terminal block 423, and then the charging current flows to the battery pack 900 through the bridge arm of the electric control module 200, thereby realizing boost charging of the battery pack 900.

Moreover, the Hall element 220 may feed back a current value on the N wire copper bar 210 to the electric control module 200 through the signal wire, and then may detect and control the current value on the N wire copper bar 210, thereby controlling a magnitude of the current value and a flow direction of the current on the N wire copper bar 210 in time and improving reliability of circuit control.

In some specific embodiments of the present disclosure, as shown in FIG. 2, the electric assembly 1 further comprises a contactor 500. A first end 5501 of the contactor 500 is configured to connect to the battery pack 900, and a second end 5502 of the contactor 500 is configured to connect to the N wire connection assembly 420. The contactor 500 may be mounted to the battery pack 900.

Therefore, on/off of the battery pack 900 and the N wire connection assembly 420 may be controlled through the contactor 500, that is, on/off of the battery pack 900 and the three-phase windings 440 is controlled, so that it is not necessary to heat the battery pack 900 all the time. In this way, when a temperature of the battery pack 900 is excessively high, an electrical connection between the battery pack 900 and the three-phase windings 440 may be cut off by opening the contactor 500, so that the temperature of the battery pack 900 may be prevented from being excessively high, which is conducive to improving electrical safety of the electric assembly 1.

In some specific embodiments of the present disclosure, as shown in FIG. 3, the N wire adapter 422 passes through the opening 431 and is then connected with the N wire lug 424. The N wire lug 424 is configured to connect to the battery pack 900 through a lead wire.

In other words, the N wire lug 424 is arranged outside the casing 410 of the motor 400, and the N wire adapter 422 may be brought into communication with the battery pack 900 through the N wire lug 424. The N wire lug 424 may be connected with one end of the lead wire, and another end of the lead wire is connected with the battery pack 900. Through this arrangement, the connection between the N wire lug 424 and the N wire adapter 422 is more convenient, the mounting and dismounting are simpler, and the connection is more reliable, further improving safety of the electrical connection after the N wire adapter 422 extends out of the opening 431. Moreover, the N wire lug 424 is connected with the battery pack 900 through the lead wire, so that the lead wire can be easily bent, the wiring is more convenient, and the layout is also more convenient, which is beneficial to reducing the volume of the electric assembly 1.

Further, as shown in FIG. 3, the motor 400 further comprises an N wire fixing base 450.

The N wire fixing base 450 is mounted to the end cover 430. The N wire adapter 422 comprises a first connector 451. The first connector 451 is inserted into the N wire fixing base 450.

Further, the N wire lug 424 comprises a second connector 425. The first connector 451 is connected with the second connector 425.

Specifically, the N wire fixing base 450 is mounted outside the casing 410 of the motor 400, and the N wire fixing base 450 may be fixedly connected with the end cover 430. When the first connector 451 of the N wire adapter 422 extends out of the opening 431, the first connector 451 may extend into the N wire fixing base 450, and then the second connector 425 of the N wire lug 424 also extends into the N wire fixing base 450. The N wire fixing base 450 may limit the first connector 451 and the second connector 425 to facilitate the connection and fixation of the first connector 451 and the second connector 425. Through this arrangement, the connection between the N wire lug 424 and the N wire adapter 422 is more convenient. In addition, the N wire fixing base 450 may occlude the first connector 451 and the second connector 425, so as to prevent the first connector 451 and the second connector 425 from being exposed, further improving the reliability and safety of the electrical connection between the first connector 451 and the second connector 425.

Still further, as shown in FIG. 3, the motor 400 further comprises an N wire mounting and dismounting cover 460.

A side of the N wire fixing base 450 facing away from the end cover 430 is provided with a mounting and dismounting port 452. The N wire mounting and dismounting cover 460 is mounted to the N wire fixing base 450 and covers the mounting and dismounting port 452. The mounting and dismounting port 452 is configured to mount and dismount at least one of the first connector 451 and the second connector 425.

In this way, during the mounting or dismounting of the first connector 451 and the second connector 425, the N wire mounting and dismounting cover 460 may be dismounted first, so that the first connector 451 and the second connector 425 can be exposed from the mounting and dismounting port 452, which is convenient for mounting and dismounting the first connector 451 and the second connector 425. In this way, the first connector 451 and the second connector 425 can be mounted and dismounted without completely disassembling the N wire fixing base 450, so that the mounting and dismounting are more convenient and faster.

Moreover, through arrangement of the mounting and dismounting port 452 on the side of the N wire fixing base 450 facing away from the end cover 430, the mounting and dismounting port 452 is less prone to positional interference with the end cover 430, and the operable space of the mounting and dismounting port 452 is larger, which is more convenient for mounting and dismounting the first connector 451 and the second connector 425 through the mounting and dismounting port 452.

In some specific embodiments of the present disclosure, as shown in FIG. 3, the motor 400 further comprises a first sealing ring 470 and a second sealing ring 480.

The first sealing ring 470 surrounds the opening 431 and is arranged between the N wire fixing base 450 and the end cover 430. The second sealing ring 480 surrounds the mounting and dismounting port 452 and is arranged between the N wire fixing base 450 and the N wire mounting and dismounting cover 460.

In this way, the first sealing ring 470 may seal a gap between the N wire fixing base 450 and the end cover 430, and the second sealing ring 480 may seal a gap between the N wire fixing base 450 and the N wire mounting and dismounting cover 460, thereby sealing an internal space of the casing 410 of the motor 400, so as to improve sealing performance of the motor 400.

In some specific embodiments of the present disclosure, as shown in FIG. 3, the electric assembly 1 further comprises a three-phase wire connection assembly 600.

The three-phase wire connection assembly 600 comprises a three-phase wire 610 and a three-phase wire terminal block 620. The three-phase wire 610 is connected with the three-phase windings 440. The three-phase wire terminal block 620 is connected with the electric control module 200. The three-phase wire terminal block 620 and the N wire terminal block 423 are integrally formed.

Through arrangement of the three-phase wire terminal block 620 (for example, the three-phase wire terminal block 620 may be an injection molded member), the reliability and safety of the electrical connection between the three-phase wire 610 and the electric control module 200 can be ensured. Moreover, the three-phase wire terminal block 620 and the N wire terminal block 423 may be integrated into one component, which can reduce the quantity of parts and components and facilitate the assembly of the three-phase wire terminal block 620 and the N wire terminal block 423, and the overall volume of the three-phase wire terminal block 620 and the N wire terminal block 423 may be smaller, which is beneficial to reducing the volume of the electric assembly 1.

In some specific embodiments of the present disclosure, as shown in FIG. 3, a peripheral surface of one end of the casing 410 close to the end cover 430 is provided with a motor terminal block slot 411, and the three-phase wire terminal block 620 passes through the motor terminal block slot 411 and is fixedly mounted to the casing 410. One end of the three-phase wire terminal block 620 connected with the motor 400 passes through the motor terminal block slot 411 and enters a cavity formed by the end cover 430 and the casing 410, and one end of the three-phase wire terminal block 620 connected with the electric control module 200 protrudes from the motor terminal block slot 411.

Therefore, after one end of the three-phase wire terminal block 620 extends into the motor terminal block slot 411, the three-phase wire terminal block 620 may seal the motor terminal block slot 411, and the casing 410 may pre-fix the three-phase wire terminal block 620 through the motor terminal block slot 411, which is convenient for assembly. Moreover, one end of the three-phase wire terminal block 620 connected with the electric control module 200 extends out of the motor terminal block slot 411, which facilitates the connection between the three-phase wire terminal block 620 and the electric control module 200, avoids the position interference between the electric control module 200 and the casing 410 of the motor 400, so that the assembly is more convenient.

In some specific embodiments of the present disclosure, as shown in FIG. 3, the electric assembly 1 further comprises a third sealing ring 700. The third sealing ring 700 surrounds the motor terminal block slot 411 and is located between the three-phase wire terminal block 620 and the end cover 430. In this way, the third sealing ring 700 may seal a gap between the three-phase wire terminal block 620 and the end cover 430, and then may seal an internal space of the casing of the motor 400, further enhancing the sealing performance of the motor 400.

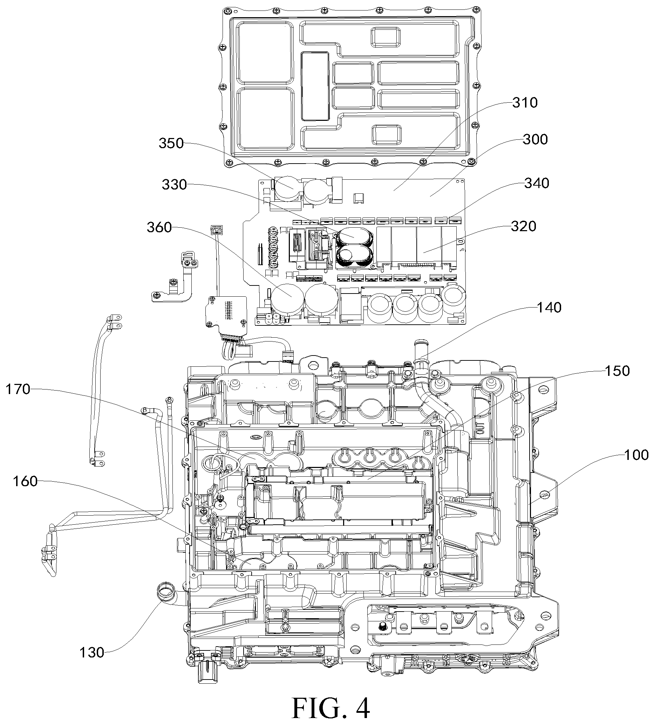

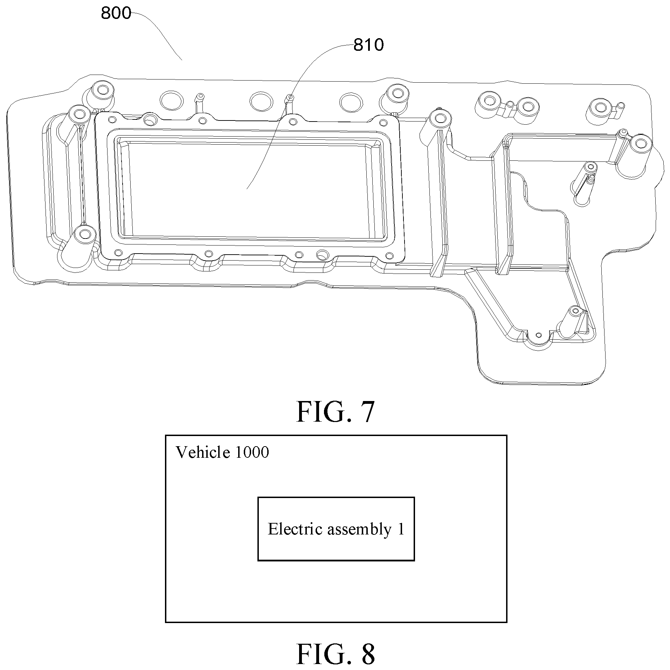

In some specific embodiments of the present disclosure, as shown in FIG. 4, the electric assembly 1 further comprises a power module 300. The power module 300 is arranged in the box 100. In addition, as shown in FIG. 7, the electric assembly 1 further comprises a water channel cover plate 800. The water channel cover plate 800 is provided with a first water channel 810. The box 100 is provided with a second water channel 110 and a third water channel 120. The water channel cover plate 800 is connected with the box 100 and covers the second water channel 110 and the third water channel 120. The water channel cover plate 800 may be integrally connected with the box 100 through friction welding.

The first water channel 810 is in communication with the second water channel 110 and the third water channel 120. The second water channel 110 is adapted to be in communication with a water inlet pipe 130, and the third water channel 120 is adapted to be in communication with a water outlet pipe 140. A cooling liquid in the second water channel 110 flows into the first water channel 810, thereby dissipating heat for the electric control module 200. A cooling liquid in the first water channel 810 flows into the third water channel 120, thereby dissipating heat for the power module 300.

In other words, the first water channel 810, the second water channel 110, and the third water channel 120 form a connected water channel, and the cooling liquid in the first water channel 810, the second water channel 110, and the third water channel 120 may be shared. Moreover, the second water channel 110 and the third water channel 120 may be sealed through the water channel cover plate 800 to prevent the cooling liquid in the second water channel 110 and the third water channel 120 from leaking out. In addition, the cooling liquid in the third water channel 120 may exchange heat with the power module 300 through an outer wall of the third water channel 120. In this way, a temperature of the power module 300 may be reduced, so that the power module 300 is maintained in a low temperature state or a normal temperature state, and then operation stability of the power module 300 may be improved, thereby preventing the power module 300 from being damaged due to the high temperature.

Moreover, the first water channel 810, the second water channel 110, and the third water channel 120 are in communication with each other. A flow path of the cooling liquid is longer. The cooling liquid in the second water channel 110 may flow into the first water channel 810 to dissipate heat for the electric control module 200, and the cooling liquid in the first water channel 810 may also flow into the third water channel 120 to dissipate heat for the power module 300. This is beneficial to increasing a utilization rate of the cooling liquid.

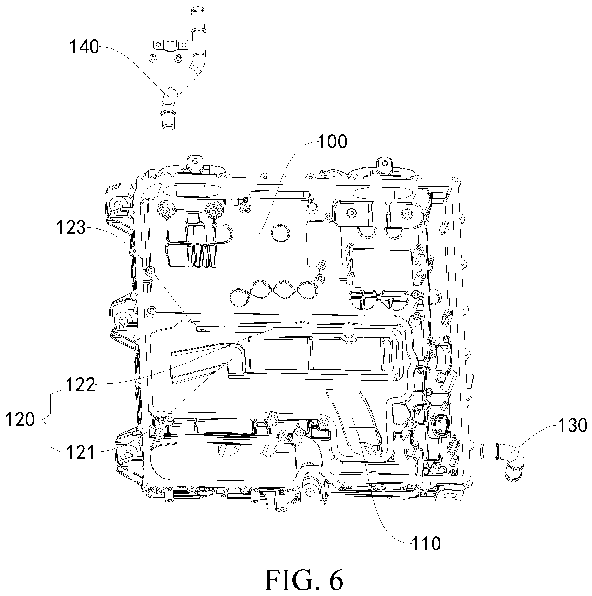

In some specific embodiments of the present disclosure, as shown in FIG. 6, the third water channel 120 comprises a transition section 121 and an annular section 122.

The transition section 121 is brought into communication with the first water channel 810. The annular section 122 surrounds the power module 300 and is configured to dissipate heat for the power module 300. One end of the annular section 122 is connected with one end of the transition section 121, and another end of the annular section 122 is provided with a water outlet hole 123. A depth of the annular section 122 is greater than a depth of the second water channel 110 and a depth of the transition section 121.

For example, the cooling liquid flows into the second water channel 110 and then into the first water channel 810. Then the cooling liquid in the first water channel 810 flows to the transition section 121, and finally flows from the transition section 121 to the annular section 122 and is discharged from the water outlet hole 123 of the annular section 122.

Moreover, a contact area between the annular section 122 and the power module 300 is larger, and a structure of the annular section 122 is more compact, which occupies a smaller space. Through the heat dissipation for the power module 300 by using the annular section 122, a heat exchange effect of the third water channel 120 and the power module 300 may be improved, and then the power module 300 can be quickly cooled down, thereby achieving a better heat dissipation effect.

In addition, the depth of the annular section 122 is greater than the depth of the second water channel 110 and the depth of the transition section 121. In this way, on the one hand, a volume of the annular section 122 may be larger, and the annular section 122 may accommodate more cooling liquids, thereby improving the heat dissipation effect of the annular section 122 on the power module 300. On the other hand, transition between the second water channel 110 and the first water channel 810 may be smoother, transition between the transition section 121 and the first water channel 810 may be smoother, and the circulating flow of the cooling liquid between the third water channel 120 and the first water channel 810 may be smoother, so that the cooling liquid can fully exchange heat with the power module 300, thereby further improving the heat dissipation effect of the power module 300.

In some specific embodiments of the present disclosure, as shown in FIG. 4, the power module 300 comprises a bottom plate 310, a transformer 320, a transformer inductor 330, multiple MOS tubes 340, an AC inductor 350, and a DC inductor 360.

The bottom plate 310 has a first direction and a second direction orthogonal to each other. The transformer 320 and the transformer inductor 330 are mounted to the bottom plate 310 and extend along the first direction. The multiple MOS tubes 340 are mounted to the bottom plate 310 and separately arranged on two opposite sides of the transformer 320 in the second direction. The AC inductor 350 and the DC inductor 360 are mounted to the bottom plate 310 and separately arranged on two opposite sides of the MOS tubes 340 in the second direction. The third water channel 120 surrounds the transformer 320 and the transformer inductor 330, and the multiple MOS tubes 340 are located on two opposite sides of the third water channel 120 and exchange heat with the third water channel 120.

In this way, the bottom plate 310 may be configured to fix the transformer 320, the transformer inductor 330, the multiple MOS tubes 340, the AC inductor 350 and the DC inductor 360. The AC inductor 350 and the DC inductor 360 may be far away from each other to avoid interference between the AC inductor 350 and the DC inductor 360. Moreover, the transformer 320, transformer inductor 330, the multiple MOS tubes 340, the AC inductor 350, and the DC inductor 360 are arranged more evenly on the bottom plate 310, thereby avoiding electromagnetic interference among multiple parts and components.

In addition, the third water channel 120 surrounds the transformer 320 and the transformer inductor 330. The multiple MOS tubes 340, the AC inductor 350, and the DC inductor 360 are located outside the third water channel 120 and attached to the outer wall of the third water channel 120. The third water channel 120 may dissipate heat for the transformer 320, the transformer inductor 330, the multiple MOS tubes 340, the AC inductor 350, and the DC inductor 360, thereby improving the heat dissipation efficiency of the power module 300.

In some specific embodiments of the present disclosure, as shown in FIG. 4, the box 100 is provided with multiple MOS tube cavities 150, an AC inductor cavity 160, and a DC inductor cavity 170. The AC inductor 350 extends into the AC inductor cavity 160, the DC inductor 360 extends into the DC inductor cavity 170, and the multiple MOS tubes 340 extend into the multiple MOS tube cavities 150 in a one-to-one correspondence manner.

In this way, the MOS tube cavity 150 may shield the MOS tube 340, the AC inductor cavity 160 may shield the AC inductor 350, the DC inductor cavity 170 may shield the DC inductor 360, and a side wall of the third water channel 120 can shield the transformer 320 and the transformer inductor 330, thereby further avoiding the electromagnetic interference among the MOS tubes 340, the AC inductor 350, the DC inductor 360, the transformer 320, and the transformer inductor 330, and avoiding the interference with external electronic devices, which is beneficial to improving electromagnetic compatibility.

A vehicle 1000 according to an embodiment of the present disclosure is described with reference to FIG. 8. The vehicle 1000 comprises an electric assembly 1 according to the embodiment of the first aspect of the present disclosure.

The vehicle 1000 according to the embodiment of the present disclosure has advantages such as a short wiring distance, a simple wiring structure, and a small volume by utilizing the electric assembly 1 according to the above embodiment of the present disclosure.

Other compositions and operations of the electric assembly 1 and the vehicle having the same according to the embodiments of the present disclosure are known to a person of ordinary skill in the art, and the details are not described herein again.

In the description of the specification, the description of reference terms such as "specific embodiments" and "specific examples" means that specific features, structures, materials, or characteristics described in combination with the embodiment or example are included in at least one embodiment or example of the present disclosure. In this specification, schematic descriptions of the above terms do not necessarily refer to the same embodiment or example.

Although the embodiments of the present disclosure have been shown and described, a person of ordinary skill in the art should understand that various changes, modifications, replacements, and variations may be made to the embodiments without departing from the principles and spirit of the present disclosure, and the scope of the present disclosure is as defined by the claims and their equivalents.

## Claims

1. An electric assembly (1), comprising:
a box (100);
an electric control module (200), the electric control module (200) being arranged in the box (100); and
a motor (400), the motor (400) being arranged in the box (100), and the motor (400) comprising:
a casing (410);
an N wire connection assembly (420), one end (4201) of the N wire connection assembly (420) being configured to connect to a battery pack (900);
an end cover (430), the end cover (430) being arranged at one end of the casing (410) and configured to block the casing (410), and an opening (431) allowing part of the N wire connection assembly (420) to pass through being formed on the end cover (430); and
three-phase windings (440), the three-phase windings (440) being arranged in the casing (410), a first end (4401) of the three-phase windings (440) being connected with the electric control module (200), and a second end (4402) of the three-phase windings (440) being connected with a junction and then connected with another end (4202) of the N wire connection assembly (420).

2. The electric assembly (1) according to claim 1, wherein the N wire connection assembly (420) comprises:
an N wire (421), a first end (4211) of the N wire (421) being connected with the second end (4402) of the three-phase windings (440);
an N wire adapter (422), a first end (4221) of the N wire adapter (422) being connected with a second end (4212) of the N wire (421), and a second end (4222) of the N wire adapter (422) passing through the opening (431); and
an N wire terminal block (423), a first end (4231) of the N wire terminal block (423) being connected with a second end (4212) of the N wire (421), and a second end (4232) of the N wire terminal block (423) being connected with an N wire copper bar (210) of the electric control module (200).

3. The electric assembly (1) according to claim 2, wherein a Hall element (220) is arranged to extend through the N wire copper bar (210), and the Hall element (220) is connected with the electric control module (200) through a signal wire.

4. The electric assembly (1) according to any of claims 1 to 3, further comprising:
a contactor (500), a first end (5001) of the contactor (500) being configured to connect to the battery pack (900), and a second end (5002) of the contactor (500) being configured to connect to the N wire connection assembly (420).

5. The electric assembly (1) according to claim 2 or 3, further comprising:
an N wire lug (424), the N wire adapter (422) passing through the opening (431) and being connected with the N wire lug (424), and the N wire lug (424) being configured to connect to the battery pack (900) through a lead wire.

6. The electric assembly (1) according to claim 5, wherein the motor (400) further comprises:
an N wire fixing base (450), the N wire fixing base (450) being mounted to the end cover (430),
wherein the N wire adapter (422) comprises a first connector (451), and the first connector (451) is inserted into the N wire fixing base (450).

7. The electric assembly (1) according to claim 6, wherein the N wire lug (424) comprises:
a second connector (425), the second connector (425) being connected with the first connector (451).

8. The electric assembly (1) according to claim 7, wherein the motor (400) further comprises:
an N wire mounting and dismounting cover (460), a side of the N wire fixing base (450) facing away from the end cover (430) being provided with a mounting and dismounting port (452), the N wire mounting and dismounting cover (460) being mounted to the N wire fixing base (450) and covering the mounting and dismounting port (452), and the mounting and dismounting port (452) being configured to mount and dismount at least one of the first connector (451) and the second connector (425).

9. The electric assembly (1) according to claim 8, wherein the motor (400) further comprises:
a first sealing ring (470), the first sealing ring (470) surrounding the opening (431) and being arranged between the N wire fixing base (450) and the end cover (430); and
a second sealing ring (480), the second sealing ring (480) surrounding the mounting and dismounting port (452) and being arranged between the N wire fixing base (450) and the N wire mounting and dismounting cover (460).

10. The electric assembly (1) according to any of claims 2 to 3 and 5 to 9, further comprising:
a three-phase wire connection assembly (600), the three-phase wire connection assembly (600) comprising:
a three-phase wire (610), the three-phase wire (610) being connected with the three-phase windings (440); and
a three-phase wire terminal block (620), the three-phase wire terminal block (620) being connected with the electric control module (200), and the three-phase wire terminal block (620) and the N wire terminal block (423) being integrally formed.

11. The electric assembly (1) according to claim 10, wherein a peripheral surface of one end of the casing (410) close to the end cover (430) is provided with a motor terminal block slot (411), the three-phase wire terminal block (620) passing through the motor terminal block slot (411) and being fixedly mounted to the casing (410), one end of the three-phase wire terminal block (620) connected with the motor (400) passing through the motor terminal block slot (411) and entering a cavity formed by the end cover (430) and the casing (410), and one end of the three-phase wire terminal block (620) connected with the electric control module (200) protrudes from the motor terminal block slot (411).

12. The electric assembly (1) according to claim 11, further comprising:
a third sealing ring (700), the third sealing ring (700) surrounding the motor terminal block slot (411) and being located between the three-phase wire terminal block (620) and the end cover (430).

13. The electric assembly (1) according to any of claims 1 to 12, further comprising:
a water channel cover plate (800), the water channel cover plate (800) being provided with a first water channel (810), the box (100) being provided with a second water channel (110) and a third water channel (120), and the water channel cover plate (800) being connected with the box (100) and covering the second water channel (110) and the third water channel (120).

14. The electric assembly (1) according to claim 13, further comprising:
a power module (300), the power module (300) being arranged in the box (100),
wherein the first water channel (810) is in communication with the second water channel (110) and the third water channel (120), the electric assembly (1) further comprising:
a water inlet pipe (130), the water inlet pipe (130) being adapted to be in communication with the second water channel (110); and
a water outlet pipe (140), the water outlet pipe (140) being adapted to be in communication with the third water channel (120),
wherein a cooling liquid in the second water channel (110) is adapted to flow into the first water channel (810) to dissipate heat for the electric control module (200), and a cooling liquid in the first water channel (810) is adapted to flow into the third water channel (120) to dissipate heat for the power module (300).

15. The electric assembly (1) according to claim 14, wherein the third water channel (120) comprises:
a transition section (121), the transition section (121) being brought into communication with the first water channel (810); and
an annular section (122), the annular section (122) surrounding the power module (300) and being configured to dissipate heat for the power module (300).

16. The electric assembly (1) according to claim 15, wherein one end of the annular section (122) is connected with one end of the transition section (121), and another end of the annular section (122) is provided with a water outlet hole (123), wherein a depth of the annular section (122) is greater than a depth of the second water channel (110) and a depth of the transition section (121).

17. A vehicle (1000), comprising the electric assembly (1) according to any of claims 1 to 16.
